# EUROPEAN PATENT SPECIFICATION

(11) **EP 3 182 577 B1**
(45) Date of publication and mention of the grant of the patent: **27.10.2021**
(21) Application number: 16204790.6
(22) Date of filing: 16.12.2016
(51) Int. Cl.: H02P 6/16, H02P 9/00, H02K 11/215, G01R 33/07

(54) **ELECTRICAL MACHINE ASSEMBLY, ELECTRICAL ENERGY GENERATION SYSTEM AND METHOD FOR CONTROLLING THE ELECTRICAL MACHINE ASSEMBLY**
ANORDNUNG EINER ELEKTRISCHEN MASCHINE, SYSTEM ZUR ERZEUGUNG VON ELEKTRISCHER ENERGIE UND VERFAHREN ZUR STEUERUNG DER ANORDNUNG EINER ELEKTRISCHEN MASCHINE
ENSEMBLE DE MACHINE ÉLECTRIQUE, SYSTÈME DE PRODUCTION D'ÉNERGIE ÉLECTRIQUE ET PROCÉDÉ DE COMMANDE D'ENSEMBLE DE MACHINE ÉLECTRIQUE

(30) Priority: 17.12.2015 IT UB20159368
(43) Date of publication of application: 21.06.2017
(73) Proprietor: ANSALDO ENERGIA S.p.A., 16152 Genova (IT)
(72) Inventor: D'AGOSTINO, Fabrizio, 16143 GENOVA (IT); BIONDI, Roberto, 16152 GENOVA (IT)
(74) Representative: Bernotti, Andrea

(56) References cited:
- DE-B- 1 257 959
- RU-C1- 2 058 658
- US-A- 5 334 923
- US-A1- 2009 091 216
- US-A1- 2013 033 215
- Ewald Fuchs ET AL: "Power Quality in Power Systems and Electrical Machines", , 24 July 2015 (2015-07-24), XP055293137, GB ISBN: 978-0-12-369536-9 Retrieved from the Internet: URL:http://services.eng.uts.edu.au/cempe/s ubjects_JGZ/eet/eet_ch6.pdf [retrieved on 2016-08-03]
- MARINKO KOVACIC ET AL: "Design of large synchronous turbo-generator monitoring system", ELECTRICAL MACHINES (ICEM), 2012 XXTH INTERNATIONAL CONFERENCE ON, IEEE, 2 September 2012 (2012-09-02), pages 1631-1636, XP032464933, DOI: 10.1109/ICELMACH.2012.6350098 ISBN: 978-1-4673-0143-5

## Description

The present invention relates to an electrical machine assembly, an electrical energy generation system comprising said electrical machine assembly and a method for controlling the electrical machine assembly.

Generally speaking, electrical energy generation systems supply electrical energy to an electrical power network and comprise an electrical machine assembly which in turn comprises a rotating electrical machine and a control device for controlling the rotating electrical machine and an electrical energy converter arranged between the rotating electrical machine and the electrical power network.

Electric machines and control devices for electric machines are disclosed in RU 2 058 658; US 5 334 923; US 2013/033215; US 2009/091216 and DE 12 57 959.

In use, the control device is configured to control the energy converter and thus the rotating electrical machine so as to regulate the torque and make it work at a stable operating point. However, in some cases, there may be sudden changes in the driving force applied to the electrical machine or in the load on the electrical power system and, as a consequence, in the torque and stall torque that could shift the operating point of the electrical machine to an unstable operating point and result in mechanical damage to the rotating electrical machine.

The purpose of the present invention is therefore to provide an electrical machine assembly that overcomes the drawbacks of the prior art.

The present invention is defined by the independent apparatus claim 1 and the independent method claim 10.

According to the present invention, there is provided a rotating electrical machine assembly comprising an electrical machine having a stator and a rotor rotating about an axis; a magnetic probe to measure a magnetic induction value of the electrical machine; a position sensor to detect the passage of the rotor in a given point of detection and emit a reference signal; and a processing unit configured to define a value of the load angle of the electrical machine based on the magnetic induction value detected and on the reference signal.

Thanks to the present invention it is possible to determine the load angle directly using the data acquired by the magnetic sensor and so control the electrical machine according to the determined load angle and reduce the risk of the electrical machine operating at an unstable operating point and being damaged.

According to another embodiment of the present invention, the magnetic probe is arranged in an air gap of the electrical machine to detect a component radial to the axis of the magnetic induction value.

According to another embodiment of the present invention, the magnetic probe is arranged in the air gap at the given detection point.

According to the present invention, the processing unit calculates a maximum value between the magnetic induction values received and calculates the value of the load angle based on the maximum value detected.

According to the present invention, the processing unit measures the time interval elapsed between the reference signal and reaching the value of zero of the magnetic induction value and calculates the value of the load angle based on said time interval.

According to the present invention, the processing unit measures the time interval elapsed between the reference signal and reaching the maximum value of the magnetic induction value and calculates the value of the load angle based on said time interval.

According to the present invention, the processing unit calculates the value of the load angle based on the rotation frequency of the electrical machine.

According to another embodiment of the present invention, the position sensor comprises a sensing element aligned radially to the axis with the detection point.

According to another embodiment of the present invention there is provided an electrical energy generation system comprising an electrical machine assembly.

According to another embodiment of the present invention, the system comprises an electrical energy converter coupled to the electrical machine and a control unit coupled to the converter and to the processing unit to receive the value of the load angle detected; the control unit being configured to control the converter based on the value of the load angle received.

According to another embodiment of the present invention, the system comprises a measuring device coupled to the electrical machine to measure electrical quantities of the electrical machine and coupled to the control unit to supply the values of the electrical quantities detected; the control unit being configured to control the converter based on the values of the electrical quantities detected.

A further purpose of the present invention is to provide a method for controlling an electrical machine assembly that reduces the inconveniences of the prior art.

According to the present invention there is provided a method for controlling an electrical machine assembly; the electrical machine assembly comprising a rotating electrical machine; the method comprising: fixing an angular position of reference; detecting magnetic induction values of the electrical machine; defining a first event when the rotor passes through the angular position of reference; defining a second event when the magnetic induction value reaches its maximum value or a zero; detecting the time interval between the first event and the second event; calculating a load angle based on the interval of time detected; controlling the electrical machine based on the load angle detected.

According to the present invention, the load angle is calculated based on the rotation frequency of the rotor.

According to another preferred embodiment of the present invention, the method comprises the step of measuring electrical quantities of the electrical machine and controlling the electrical machine based on the electrical quantities measured and on the load angle.

The present invention will now be described with reference to the accompanying drawings, illustrating some non-limiting embodiments thereof, in which:
- figure 1 is a schematic diagram of an electrical energy generation system according to the present invention; and
- figure 2 is a front view, with parts shown as cross-sectional views, of an electrical machine of the electrical energy generation system according to the present invention.

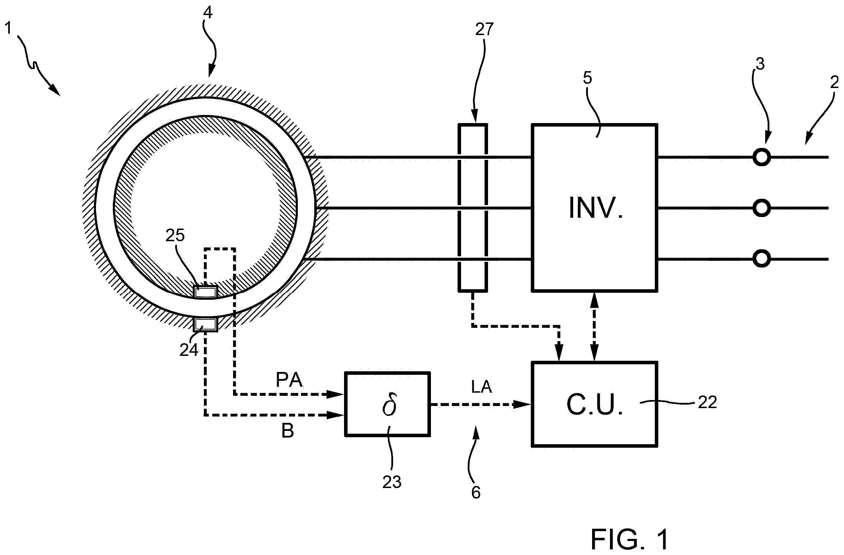

In figure 1, denoted as a whole by reference numeral 1 is an electrical energy generation system. The electrical energy generation system 1 supplies electrical energy to an electrical power network 2 at a point of exchange 3.

The electrical energy generation system 1 comprises a a rotating electrical machine 4, an electrical energy converter 5 coupled to the electrical machine 2, a control device 6 coupled to the electrical energy converter 5 and to the electrical machine 4.

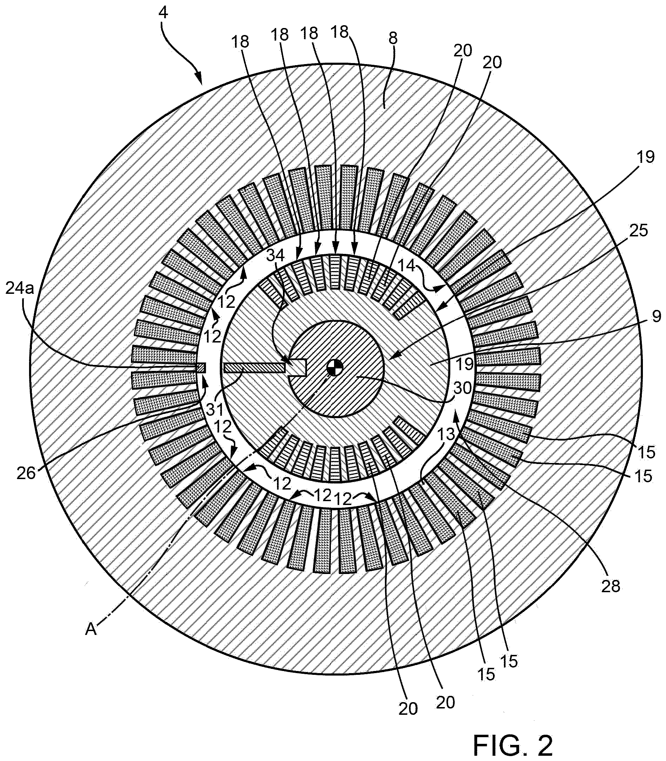

With reference to figure 2, the electrical machine 4 is a synchronous electrical machine and comprises a stator 8, and a rotor 9 coaxial with respect to one another about the axis A. In more detail, the electrical machine 4 is a two-pole machine. In another example, the electrical machine 4 has more than two poles.

The stator 8 is hollow and comprises a plurality of stator slots 12 and a plurality of stator teeth 13 spaced at intervals and formed along an inside surface 14 of the stator 8. Moreover, the stator 8 comprises a plurality of windings 15 housed in the plurality of slots 12.

The rotor 9 defines a magnetic field and comprises a plurality of rotor slots 18 formed along an outside surface 19 of the rotor 9. In particular, the plurality of slots 18 are grouped in two groups 18a of slots 18 so as to define two poles of the rotor 9.

The rotor 9 comprises windings 20 housed in the slots 18 to define a magnetic field. In another example of the present invention not illustrated in the accompanying figures, the rotor comprises permanent magnets housed in the rotor slots to define a magnetic field.

With reference to figure 1, the control device 6 comprises a control unit 22, a processing unit 23 in communication with the control unit 22, a magnetic sensor 24 in communication with the processing unit 23 to provide a magnetic induction value B, a position sensor 25 in communication with the processing unit 23 and configured to provide an angular position PA of the rotor 9, and a measuring device 27 to measure electrical quantities of the electrical machine 4.

With reference to figures 1 and 2, the magnetic sensor 24 comprises a magnetic probe 24a which is arranged inside the stator 8 at a point 26 of detection. The magnetic probe 24a is arranged in an air gap 28 between the rotor 9 and the stator 8. In more detail, the detection point 26 is arranged on one of the teeth 13 of the stator 8. Throughout this description, the term magnetic field refers to the magnetic induction B.

The magnetic sensor 24 is a magnetic field or magnetic induction sensor. In other words, the magnetic sensor 24 is configured to measure a magnetic induction value B at the detection point 26. In more detail, the magnetic sensor 24 is configured to measure the component radial to the axis A of the magnetic induction value B at the point 26. The magnetic sensor 24 is a Hall effect sensor. In another example of the present invention, the magnetic sensor 24 is any kind of sensor configured to measure a magnetic induction value B in particular a component radial to the axis A of the magnetic induction B.

With reference to figure 2, the position sensor 25 comprises a shaped wheel 30 integral with the rotor 9 and a sensing element 31 which faces the shaped wheel 30 to detect the angular position PA of the shaped wheel 30. In particular, the position sensor 25 is an encoder. The sensing element 31 is integral with the stator 8. In other words, the sensing element 31 does not rotate. The shaped wheel 30 comprises a groove 34. The sensing element 31 is arranged in a given angular position so as to detect the passage of the groove 34 when the groove 34 is aligned with the detection point 26. In other words, the position sensor 25 is configured to detect an angular position PA of the rotor 9 with respect to the detection point 26 that defines an initial reference point of the measurement, in other words the angular position with a value of 0. In more detail, the sensing element 31 and the detection point 26 are aligned radially to the axis A. In other words, the angular position of the sensing element 31 is equal to the angular position of the detection point 26 and of the magnetic probe 24a. The detection by the position sensor 25 of the passage of the groove 34 defines an angular position value PA equal to zero which in turn defines a reference signal. The reference signal defines a trigger signal.

The sensing element 31 may be of the optical, magnetic or any other type.

In another example that is not illustrated in the accompanying figures, the position sensor is not necessarily an encoder and may be any type of position sensor for example optical, magnetic or any other type.

With reference to figure 1, the processing unit 23 is connected to the magnetic sensor 24 to receive the magnetic induction value B and to the position sensor 25 to receive the reference signal.

The processing unit 23 is configured to calculate the value of a load angle LA of the electrical machine 4 based on the magnetic induction values B detected and on the reference signal.

In more detail, the processing unit 23 is configured to calculate the time interval elapsed between a first event which occurs when the position sensor 25 detects the passage of the rotor 9 through the angular position PA of reference (angular position PA having a value equal to 0), i.e., when it receives the reference signal (or trigger signal); and a second event that occurs when the measured magnetic induction value B reaches its maximum value. The processing unit 23 calculates the load angle LA based on said time interval. In more detail, the magnetic induction value B detected is approximable to a sinusoidally varying magnetic induction function FB, the processing unit 23 defines the magnetic induction function FB based on the magnetic induction values B detected, then calculates the first derivative and the second derivative of the magnetic induction function FB and determines the second event when the first derivative of the magnetic induction function FB is equal to zero and the second derivative of the magnetic induction function FB is negative. In other words, the reference signal is used as a trigger signal to determine the start of counting of the time interval.

In another embodiment, the processing unit 23 determines the second event, i.e., the instant in time when the maximum value of the magnetic induction value B is reached, by comparing the magnetic induction values B measured in succession and detecting when the measured values decrease by a given percentage, in this case the processing unit 23 associates the maximum value with the maximum value detected up to the defined percentage decrease.

The processing unit 23 calculates the rotation frequency of the electrical machine 4 according to the position signal PA. In another embodiment, the processing unit 23 receives the rotation frequency from the control unit 22 which in turn determines the rotation frequency based on the electrical quantities measured by the measuring device 27.

The processing unit 23 defines the value of the load angle LA based on the measured time interval and based on the rotation frequency, in particular by multiplying the measured time interval by the rotation frequency.

In another embodiment of the present invention, the processing unit 23 is configured to calculate the time interval elapsed between a first event which occurs when the position sensor 25 detects the passage of the rotor 9 through the angular position PA of reference (angular position PA having a value equal to 0), i.e., when it receives the reference signal (or trigger signal); and a third event that occurs when the measured magnetic induction value B reaches the zero value. The processing unit 23 calculates the load angle LA based on said time interval. In more detail, the magnetic induction value B detected is approximable to a sinusoidally varying magnetic induction function FB, the processing unit 23 defines the magnetic induction function FB based on the magnetic induction values B detected, and determines the third event when the value of the magnetic induction function FB is equal to zero. In other words, the reference signal is used as the trigger signal to determine the start of counting of the time interval.

The processing unit 23 calculates the rotation frequency of the electrical machine 4 according to the position signal PA. In another embodiment, the processing unit 23 receives the rotation frequency from the control unit 22 which in turn determines the rotation frequency based on the electrical quantities measured by the measuring device 27.

The processing unit 23 defines the value of the load angle LA based on the measured time interval and based on the rotation frequency, in particular according to the formula LA = 90° - (DT * Wr), where LA is the load angle, DT is the measured time interval and Wr is the rotation frequency.

In another embodiment of the present invention, the processing unit 23 receives the angular position PA corresponding to the magnetic induction value B detected. In other words, the processing unit 23 receives the magnetic induction value B and the angular position PA measured with the magnetic induction B measurement, at all times. Furthermore, the processing unit 23 is configured to associate the magnetic induction value B detected with the angular position PA of the rotor 9 and define a pair of values in which each magnetic induction value B detected is associated with the angular position PA of the rotor 9. In said embodiment of the present invention, the processing unit 23 is configured to calculate the value of a load angle LA of the electrical machine 4 based on the magnetic induction values B detected and the angular positions PA associated with the magnetic induction values B detected.

The measuring device 27 is associated with the electrical machine 4 to measure at least one from among the following electrical quantities: the stator voltage, the stator current and the excitation current. The measuring device 27 sends the electrical quantities measured to the control unit 22.

The control unit 22 receives the value of the load angle LA from the processing unit 23 and is configured to control the energy converter 5 based on the value of the load angle LA detected and based on the electrical quantities measured by the measuring device 27.

Thanks to the present invention, the value of the load angle LA of the electrical machine 4 is calculated at all times and in real time and is not estimated as is the case in the prior art solutions based on a mathematical model of the electrical machine 4. This means that the value of the
load angle LA has a higher resolution and a lower level of uncertainty, which results in more efficient control of the electrical energy converter 5. In other words, using the value of the load angle LA value measured in real time reduces malfunctions of the electrical machine 4 and reduces the possibility of the electrical machine 4 entering an unstable operating point at which the speed of the rotor 9 could increase without limit resulting in mechanical damage to the electrical machine 4.

## Claims

1. Electrical machine assembly comprising a rotating electrical machine (4) having a stator (8) and a rotor (9) rotating about an axis (A) ; a magnetic probe (24a) configured to measure a magnetic induction value (B) of the electrical machine (4); a position sensor (25) configured to detect the passage of the rotor (9) in a given point (26) of detection and define a reference signal (PA); and a processing unit (23) configured to define a value of the load angle (LA) of the electrical machine (4) based on the magnetic induction value (B) detected and on the reference signal (PA); **characterized in that**
the processing unit (23) is configured to measure a time interval elapsed between the reference signal (PA) and reaching the magnetic induction value (B) equal to zero or to a maximum value previously calculated by the processing unit (23) among the magnetic induction values (B) received; and is configured to calculate the value of the load angle (LA) based on said time interval;
wherein the load angle (LA) of the electrical machine is determined by multiplying the measured time interval with a rotation frequency.

2. Electrical machine assembly according to claim 1; wherein the magnetic probe (24a) is arranged in an air gap (28) of the electrical machine (4) to detect a component radial to the axis (A) of the magnetic induction value (B).

3. Electrical machine assembly according to claim 1 or 2; wherein the magnetic probe (24a) is arranged in an air gap (28) at the given detection point (26).

4. Electrical machine assembly according to any one of the preceding claims, wherein the position sensor (25) comprises a sensing element (31) aligned radially with the axis (A) with the detection point (26).

5. Electrical machine assembly according to any one of the preceding claims, wherein the position sensor (25) detects an angular position (PA) and sends it to the processing unit (23); the processing unit (23) defines pairs of values, each of which comprises a magnetic induction value (B) detected and the angular position (PA) associated with the magnetic induction value (B); the processing unit (23) defines the load angle (LA) based on said pairs of values.

6. Electrical energy generation system comprising an electrical machine assembly according to any one of the preceding claims.

7. Generation system according to claim 6, comprising an electrical energy converter (5) coupled to the electrical machine (4) and a control unit (22) coupled to the converter (5) and to the processing unit (23) to receive the value of the load angle (LA) detected; the control unit (22) being configured to control the converter (5) based on the value of the load angle (LA) received.

8. Generation system according to claim 7, comprising a measuring device (27) coupled to the electrical machine (4) to measure electrical quantities of the electrical machine and coupled to the control unit (22) to supply the values of the electrical quantities detected; the control unit (22) being configured to control the converter (5) based on the values of the electrical quantities detected.

9. Control method of an electrical machine assembly; the electrical machine assembly comprising a rotating electrical machine (4); the method comprising: fixing an angular position (PA) of reference; detecting magnetic induction values (B) of the electrical machine (4); defining a first event when the rotor passes through the angular position (PA) of reference; defining a second event when the magnetic induction value (B) reaches its maximum value or a zero value; detecting a time interval between the first event and the second event; calculating a load angle (LA) based on the interval of time detected; controlling the electrical machine (4) based on the load angle (LA) detected;
wherein the load angle (LA) of the electrical machine is determined by multiplying the measured time interval with a rotation frequency.

10. Method according to claim 9, comprising the step of measuring electrical quantities of the electrical machine (4) and controlling the electrical machine based on the electrical quantities measured and on the load angle.

## Patentansprüche

1. Elektrische Maschinenanordnung, umfassend eine rotierende elektrische Maschine (4) mit einem Stator (8) und einem Rotor (9), der sich um eine Achse (A) dreht; eine magnetische Sonde (24a), die dafür konfiguriert ist, einen magnetischen Induktionswert (B) der elektrischen Maschine (4) zu messen; einen Positionssensor (25), der dafür konfiguriert ist, den Durchgang des Rotors (9) an einem vorgegebenen Erfassungspunkt (26) zu erfassen und ein Referenzsignal (PA) zu definieren; und eine Verarbeitungseinheit (23), die dafür konfiguriert ist, einen Wert des Lastwinkels (LA) der elektrischen Maschine (4) auf der Grundlage des erfassten magnetischen Induktionswertes (B) und des Referenzsignals (PA) zu definieren; **dadurch gekennzeichnet, dass** die Verarbeitungseinheit (23) dafür konfiguriert ist, ein Zeitintervall zu messen, das zwischen dem Referenzsignal (PA) und dem Erreichen des magnetischen Induktionswerts (B), der gleich Null oder gleich einem Maximalwert ist, der zuvor von der Verarbeitungseinheit (23) unter den empfangenen magnetischen Induktionswerten (B) berechnet worden ist, verstrichen ist; und dafür konfiguriert ist, den Wert des Lastwinkels (LA) auf der Grundlage des Zeitintervalls zu berechnen; wobei der Lastwinkel (LA) der elektrischen Maschine durch Multiplizieren des gemessenen Zeitintervalls mit einer Drehfrequenz bestimmt wird.

2. Elektrische Maschinenanordnung nach Anspruch 1; wobei die magnetische Sonde (24a) in einem Luftspalt (28) der elektrischen Maschine (4) angeordnet ist, um eine zu der Achse (A) radiale Komponente des magnetischen Induktionswertes (B) zu erfassen.

3. Elektrische Maschinenanordnung nach Anspruch 1 oder 2;
wobei die magnetische Sonde (24a) in einem Luftspalt (28) an der vorgegebenen Erfassungsstelle (26) angeordnet ist.

4. Elektrische Maschinenanordnung nach einem der vorangehenden Ansprüche, wobei der Positionssensor (25) ein Sensorelement (31) umfasst, das auf den Erfassungspunkt (26) radial zu der Achse (A) ausgerichtet ist.

5. Elektrische Maschinenanordnung nach einem der vorangehenden Ansprüche, wobei der Positionssensor (25) eine Winkelposition (PA) erfasst und an die Verarbeitungseinheit (23) sendet; wobei die Verarbeitungseinheit (23) Wertepaare definiert, von denen jedes einen erfassten magnetischen Induktionswert (B) und die dem magnetischen Induktionswert (B) zugeordnete Winkelposition (PA) umfasst; wobei die Verarbeitungseinheit (23) den Lastwinkel (LA) auf der Grundlage dieser Wertepaare definiert.

6. Elektrisches Energieerzeugungssystem, das eine elektrische Maschinenanordnung nach einem der vorangehenden Ansprüche umfasst.

7. Erzeugungssystem nach Anspruch 6, umfassend einen elektrischen Energiewandler (5), der mit der elektrischen Maschine (4) gekoppelt ist, und eine Steuer-/Regeleinheit (22), die mit dem Wandler (5) und der Verarbeitungseinheit (23) gekoppelt ist, um den erfassten Wert des Lastwinkels (LA) zu empfangen; wobei die Steuer-/Regeleinheit (22) dafür konfiguriert ist, den Wandler (5) auf der Grundlage des empfangenen Wertes des Lastwinkels (LA) zu steuern.

8. Erzeugungssystem nach Anspruch 7, umfassend eine Messeinrichtung (27), die mit der elektrischen Maschine (4) gekoppelt ist, um elektrische Größen der elektrischen Maschine zu messen, und mit der Steuer-/Regeleinheit (22) gekoppelt ist, um die Werte der erfassten elektrischen Größen bereitzustellen; wobei die Steuer-/Regeleinheit (22) dafür konfiguriert ist, den Wandler (5) auf der Grundlage der Werte der erfassten elektrischen Größen zu steuern.

9. Verfahren zur Steuerung/Regelung einer elektrischen Maschinenanordnung; wobei die elektrische Maschinenanordnung eine rotierende elektrische Maschine (4) umfasst; wobei das Verfahren umfasst: Festlegen einer Referenzwinkelposition (PA); Erfassen von magnetischen Induktionswerten (B) der elektrischen Maschine (4); Definieren eines ersten Ereignisses, wenn der Rotor die Referenzwinkelposition (PA) durchläuft; Definieren eines zweiten Ereignisses, wenn der magnetische Induktionswert (B) seinen Maximalwert oder einen Nullwert erreicht; Erfassen eines Zeitintervalls zwischen dem ersten Ereignis und dem zweiten Ereignis; Berechnen eines Lastwinkels (LA) auf der Grundlage des erfassten Zeitintervalls; und Steuern/Regeln der elektrischen Maschine (4) auf der Grundlage des erfassten Lastwinkels (LA); wobei der Lastwinkel (LA) der elektrischen Maschine durch Multiplizieren des gemessenen Zeitintervalls mit einer Drehfrequenz bestimmt wird.

10. Verfahren nach Anspruch 9, umfassend den Schritt des Messens elektrischer Größen der elektrischen Maschine (4) und des Steuerns/Regelns der elektrischen Maschine auf der Grundlage der gemessenen elektrischen Größen und des Lastwinkels.

## Revendications

1. Ensemble machine électrique comprenant une machine électrique tournante (4) ayant un stator (8) et un rotor (9) tournant autour d'un axe (A) ; une sonde magnétique (24a) conçue pour mesurer une valeur d'induction magnétique (B) de la machine électrique (4) ; un capteur de position (25) conçu pour détecter le passage du rotor (9) à un point donné (26) de détection et définir un signal de référence (PA) ; et une unité de traitement (23) conçue pour définir une valeur de l'angle de charge (LA) de la machine électrique (4) sur la base de la valeur d'induction magnétique (B) détectée et du signal de référence (PA) ; **caractérisé en ce que** l'unité de traitement (23) est conçue pour mesurer un intervalle de temps écoulé entre le signal de référence (PA) et l'obtention de la valeur d'induction magnétique (B) égale à zéro ou à une valeur maximale calculée précédemment par l'unité de traitement (23) parmi les valeurs d'induction magnétique (B) reçues ; et est conçue pour calculer la valeur de l'angle de charge (LA) sur la base dudit intervalle de temps ; dans lequel l'angle de charge (LA) de la machine électrique est déterminé en multipliant l'intervalle de temps mesuré par une fréquence de rotation.

2. Ensemble machine électrique selon la revendication 1 ; dans lequel la sonde magnétique (24a) est agencée dans un entrefer (28) de la machine électrique (4) pour détecter un composant radial par rapport à l'axe (A) de la valeur d'induction magnétique (B).

3. Ensemble machine électrique selon la revendication 1 ou 2 ; dans lequel la sonde magnétique (24a) est agencée dans un entrefer (28) au point de détection donné (26).

4. Ensemble machine électrique selon l'une quelconque des revendications précédentes, dans lequel le capteur de position (25) comprend un élément de détection (31) aligné radialement par rapport à l'axe (A) avec le point de détection (26).

5. Ensemble machine électrique selon l'une quelconque des revendications précédentes, dans lequel le capteur de position (25) détecte une position angulaire (PA) et l'envoie à l'unité de traitement (23) ; l'unité de traitement (23) définit des paires de valeurs, dont chacune comprend une valeur d'induction magnétique (B) détectée et la position angulaire (PA) associée à la valeur d'induction magnétique (B) ; l'unité de traitement (23) définit l'angle de charge (LA) sur la base desdites paires de valeurs.

6. Système de génération d'énergie électrique comprenant un ensemble machine électrique selon l'une quelconque des revendications précédentes.

7. Système de génération selon la revendication 6, comprenant un convertisseur d'énergie électrique (5) couplé à la machine électrique (4) et une unité de commande (22) couplée au convertisseur (5) et à l'unité de traitement (23) pour recevoir la valeur de l'angle de charge (LA) détecté ; l'unité de commande (22) étant conçue pour commander le convertisseur (5) sur la base de la valeur de l'angle de charge (LA) reçu.

8. Système de génération selon la revendication 7, comprenant un dispositif de mesure (27) couplé à la machine électrique (4) pour mesurer des quantités électriques de la machine électrique et couplé à l'unité de commande (22) pour fournir les valeurs des quantités électriques détectées ; l'unité de commande (22) étant conçue pour commander le convertisseur (5) sur la base des valeurs des quantités électriques détectées.

9. Procédé de commande d'un ensemble machine électrique ; l'ensemble machine électrique comprenant une machine électrique tournante (4) ; le procédé comprenant : la fixation d'une position angulaire (PA) de référence ; la détection de valeurs d'induction magnétique (B) de la machine électrique (4) ; la définition d'un premier événement lorsque le rotor traverse la position angulaire (PA) de référence ; la définition d'un deuxième événement lorsque la valeur d'induction magnétique (B) atteint sa valeur maximale ou une valeur nulle ; la détection d'un intervalle de temps entre le premier événement et le deuxième événement ; le calcul d'un angle de charge (LA) sur la base de l'intervalle de temps détecté ; la commande de la machine électrique (4) sur la base de l'angle de charge (LA) détecté ; dans lequel l'angle de charge (LA) de la machine électrique est déterminé en multipliant l'intervalle de temps mesuré par une fréquence de rotation.

10. Procédé selon la revendication 9, comprenant l'étape de mesure de quantités électriques de la machine électrique (4) et de commande de la machine électrique sur la base des quantités électriques mesurées et de l'angle de charge.
